# EUROPEAN PATENT APPLICATION

(11) **EP 4 757 529 A1**
(43) Date of publication of application: **10.06.2026**
(21) Application number: 24848638.3
(22) Date of filing: 20.05.2024
(51) Int. Cl.: H10D 30/60, H10D 62/80

(54) **FIELD-EFFECT TRANSISTOR**

(30) Priority: 31.07.2023 JP 2023124922
(71) Applicant: DENSO CORPORATION, Kariya-shi, Aichi 448-8661 (JP)
(72) Inventor: TAKAYA Hidefumi, Kariya-shi, Aichi 448-8661 (JP)
(74) Representative: Kuhnen & Wacker Patent- und Rechtsanwaltsbüro PartG mbB
(86) International application number: PCT/JP2024/018533
(87) International publication number: WO 2025/027977

(57) **Abstract**

A recovery current is suppressed in a field-effect transistor having a deep layer. In the field-effect transistor, when a semiconductor substrate is viewed from above, contact layers are arranged at interval in a specific direction parallel to trenches in each inter-trench region. When the semiconductor substrate is viewed from above, deep layers are arranged at interval in the specific direction in each inter-trench region. In each inter-trench region, each interval between the contact layers is located above a corresponding one of the deep layers. In each inter-trench region, each interval between the deep layers is located below a corresponding one of the contact layers.

## Description

### TECHNICAL FIELD

### CROSS REFERENCE TO RELATED APPLICATIONS

This application is a related application of Japanese Patent Application No. 2023-124922 filed on July 31, 2023, and claims priority based on this Japanese patent application. All contents described in this Japanese patent application are incorporated herein by reference.

The present disclosure relates to a field-effect transistor.

A field-effect transistor disclosed in JP 2001-267570 A has a trench-type gate electrode. The field-effect transistor has a p-type deep layer (called an electric field shield region on a lower side of base region) that extends downward from a p-type body layer (called a base region). The deep layer extends to a position below the lower end of the trench. A p-type contact layer that connects the body layer and the source electrode is provided above the deep layer. The contact layer is provided to stabilize the potential of the body layer. The deep layer is provided to reduce the electric field strength of the gate insulating film in the trench.

### SUMMARY OF INVENTION

When the potential of the source electrode increases, a forward voltage is applied to the pn junction at the interface between the body layer and the drift layer. As a result, the diode formed by the pn junction turns on, and holes flow from the body layer into the drift layer. When the potential of the source electrode is subsequently reduced, the holes in the drift layer flow to the source electrode via the deep layer, the body layer, and the contact layer. The current generated by the holes flowing to the source electrode in this manner is called a recovery current. When the recovery current flows, a surge voltage occurs in the field-effect transistor. In the field-effect transistor of JP 2001-267570 A, a high recovery current is likely to occur. This specification proposes a technique for suppressing recovery current in a field-effect transistor having a deep layer.

A field-effect transistor disclosed in this specification includes: a semiconductor substrate made of a compound semiconductor and having trenches formed on an upper surface; gate electrodes respectively disposed in the trenches and insulated from the semiconductor substrate by a gate insulating film; and a source electrode in contact with the upper surface of the semiconductor substrate. The semiconductor substrate has plural n-type source layers, plural p-type contact layers, a p-type body layer, an n-type drift layer, and plural p-type deep layers. A semiconductor region of the semiconductor substrate located between the trenches is an inter-trench region. The source layers are respectively disposed in the inter-trench regions, and in contact with the source electrode and with the gate insulating film. The contact layers are respectively disposed in the inter-trench regions, and in contact with the source electrode. The contact layers are provided in each of the inter-trench regions. When the semiconductor substrate is viewed from above, in each of the inter-trench regions, the contact layers are arranged at interval in a specific direction parallel to the trenches. The body layer has a lower p-type impurity concentration than each of the contact layers, and is distributed across the inter-trench regions to be located below each of the source layers and each of the contact layers, in contact with the gate insulating film. The drift layer is distributed across the lower regions of the inter-trench regions, in contact with the body layer from below in each of the inter-trench regions, and in contact with the gate insulating film. Each of the deep layers extends from the body layer to a position lower than the lower end of each of the trenches. When the semiconductor substrate is viewed from above, the deep layers are arranged at interval in the specific direction, in each of the inter-trench regions. In each of the inter-trench regions, each interval of the contact layers is located above a corresponding one of the deep layers. In each of the inter-trench regions, each interval of the deep layers is located below a corresponding one of the contact layers.

In the field-effect transistor, each interval of the contact layers is located above the deep layer, and each interval of the deep layers is located below the contact layer. This reduces the area where the contact layer and the deep layer overlap in the up-down direction. Therefore, the resistance of the path from the drift layer through the deep layer, the body layer, and the contact layer to the source electrode (i.e., the path through which the recovery current flows) is high. Therefore, the recovery current can be suppressed in the field-effect transistor.

### BRIEF DESCRIPTION OF DRAWINGS

FIG. 1 is a perspective view showing an xz cross-section and a yz cross-section of a switching element.
FIG. 2 is an xz cross-sectional view of the switching element at a position not including a deep layer.
FIG. 3 is an xz cross-sectional view of the switching element at a position including a deep layer.
FIG. 4 is a yz cross-sectional view of the switching element at a position not including a trench.
FIG. 5 is a plan view illustrating an upper surface of a semiconductor substrate.
FIG. 6 is a graph showing impurity concentration distributions in a contact region, a body region, and a source region.
FIG. 7 is a graph showing a drain current and a drain voltage during a recovery operation.
FIG. 8 is a graph showing a relationship between a depth D and a surge voltage.
FIG. 9 is a plan view of a switching element according to a first modification, corresponding to FIG. 5.
FIG. 10 is a graph showing a relationship between a width W and a reduction rate of surge voltage.
FIG. 11 is a plan view of a switching element according to a second modification, corresponding to FIG. 5.
FIG. 12 is a plan view of a switching element according to a third modification, corresponding to FIG. 5.
FIG. 13 is a plan view of a switching element according to a fourth modification, corresponding to FIG. 5.
FIG. 14 is a plan view of a switching element according to a fifth modification, corresponding to FIG. 5.

### DESCRIPTION OF EMBODIMENTS

In one example disclosed in the present specification, when the semiconductor substrate is viewed from above, each of the deep layers may intersect with each of the trenches.

According to this configuration, the electric field strength in the gate insulating film can be further reduced.

In one example disclosed in the present specification, the contact layers and the deep layers may not overlap each other when the semiconductor substrate is viewed from above. In this case, the width of the interval between the contact layers can be made wider than the width of the deep layer, and the width of the interval between the deep layers can be made wider than the width of the contact layer.

According to this configuration, the recovery current can be suppressed more effectively.

In one example disclosed in the present specification, in each of the inter-trench regions, the interval between the deep layers may have: a first part that overlaps with the contact layer when the semiconductor substrate is viewed from above; and a second part that does not overlap with the contact layer when the semiconductor substrate is viewed from above.

In one example disclosed in the present specification, a lower end of each of the contact layers may be located at the same position as or higher than a lower end of each of the source layers in a thickness direction of the semiconductor substrate.

According to this configuration, depletion of the contact layer can be suppressed, so that the recovery current can be suppressed more effectively.

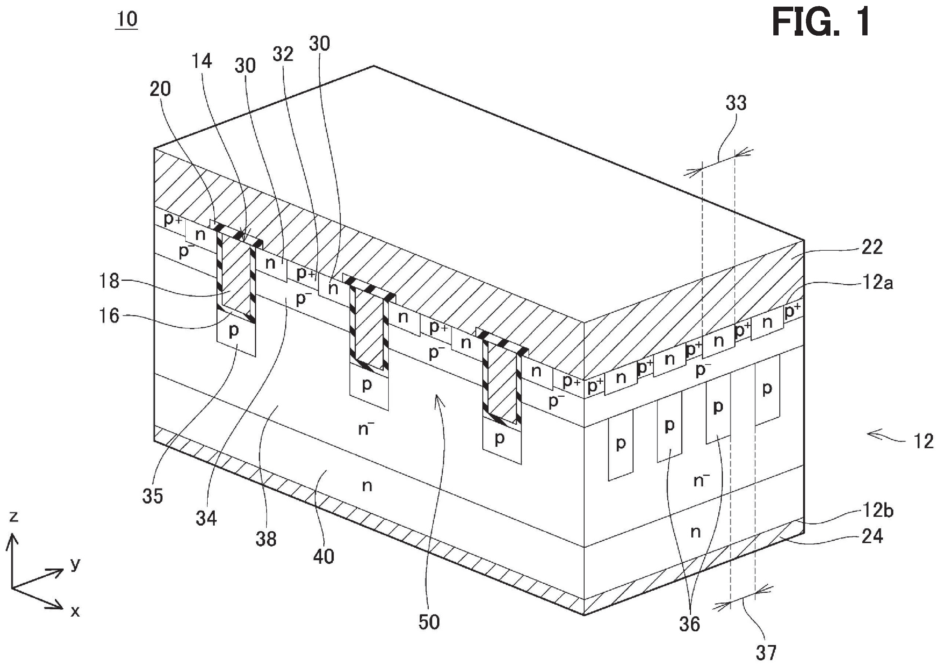

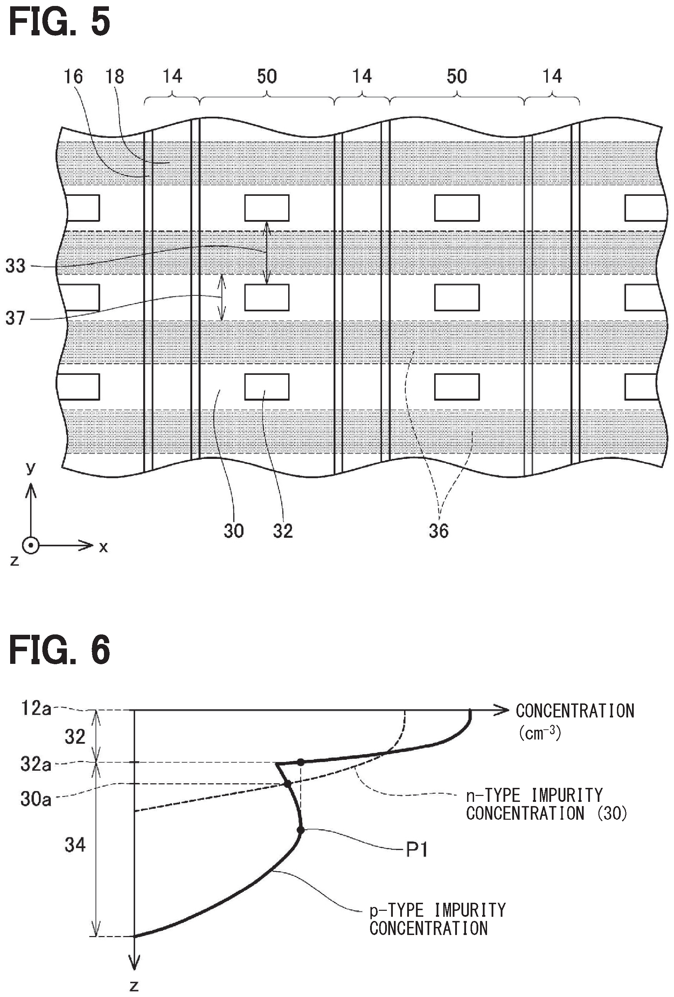

According to an embodiment, as shown in FIG. 1, a metal-oxide-semiconductor field effect transistor (MOSFET) 10 includes a semiconductor substrate 12. In the following, a thickness direction of the semiconductor substrate 12 is referred to as z direction. A direction parallel to an upper surface 12a of the semiconductor substrate 12 (perpendicular to the z direction) is referred to as x direction. A direction perpendicular to the x direction and the z direction is referred to as y direction. The semiconductor substrate 12 is made of silicon carbide (SiC). The semiconductor substrate 12 may be made of other compound semiconductors such as gallium nitride and gallium oxide. Trenches 14 are provided in the upper surface 12a of the semiconductor substrate 12. As shown in FIG. 5, the trench 14 extends in the y direction on the upper surface 12a. The trenches 14 are arranged at interval in the x direction. In the following description, each semiconductor region located between the trenches 14 is referred to as an inter-trench region 50.

As shown in FIGS. 1 to 3, an inner surface (that is, a bottom surface and a side surface) of each of the trenches 14 is covered with a gate insulating film 16. A gate electrode 18 is disposed in each of the trenches 14. The gate electrode 18 is insulated from the semiconductor substrate 12 by the gate insulating film 16. An upper surface of each of the gate electrodes 18 is covered with an interlayer insulating film 20. A source electrode 22 is disposed on the semiconductor substrate 12. The source electrode 22 covers each of the interlayer insulating films 20. The source electrode 22 is insulated from the gate electrode 18 by the interlayer insulating film 20. The source electrode 22 is in contact with the upper surface 12a of the semiconductor substrate 12 at position where the interlayer insulating film 20 is not provided. The drain electrode 24 is disposed at position directly below the semiconductor substrate 12. The drain electrode 24 is in contact with the entire region of the lower surface 12b of the semiconductor substrate 12.

The semiconductor substrate 12 has plural source layers 30, plural contact layers 32, a body layer 34, plural deep layers 36, plural under-trench layers 35, a drift layer 38, and a drain layer 40.

Each of the contact layers 32 is a p-type layer having a high p-type impurity concentration. As shown in FIGS. 1, 2, 4 and 5, each of the contact layers 32 is disposed in the inter-trench region 50. Each of the contact layers 32 is disposed in a range including the upper surface 12a of the semiconductor substrate 12. The plural contact layers 32 are provided in each of the inter-trench regions 50. Each of the contact layers 32 is disposed at position not in contact with the trench 14. In each of the inter-trench regions 50, the contact layers 32 are arranged at intervals in the y direction (i.e., the direction parallel to the trenches 14 on the upper surface 12a). Hereinafter, the region between the contact layers 32 in the y direction will be referred to as an interval 33. Each of the contact layers 32 is in ohmic contact with the source electrode 22.

Each of the source layers 30 is an n-type layer having a high n-type impurity concentration. As shown in FIGS. 1 to 5, each of the source layers 30 is disposed in the inter-trench region 50. Each of the source layers 30 is provided in a range that includes the upper surface 12a of the semiconductor substrate 12 and in a range in which the contact layer 32 is not provided. That is, each of the source layers 30 is provided in an area adjacent to the trench 14 and within the interval 33. The source layer 30 is in contact with the side surface of the contact layer 32. Each of the source layers 30 is in ohmic contact with the source electrode 22. Each of the source layers 30 is in contact with the gate insulating film 16 at an uppermost portion of the side surface of the trench 14. Each of the source layers 30 faces the gate electrode 18 with the gate insulating film 16 interposed therebetween.

The body layer 34 is a p-type layer having a lower p-type impurity concentration than the contact layers 32. As shown in FIGS. 1 to 3, the body layer 34 is distributed across the plural inter-trench regions 50. The body layer 34 is disposed below the source layers 30 and the contact layers 32. The body layer 34 is in contact with the source layers 30 and the contact layers 32 from below. The body layer 34 is in contact with the gate insulating films 16, on the side surface of the trench 14 located below the source layer 30. The body layer 34 faces the gate electrode 18 with the gate insulating film 16 interposed therebetween.

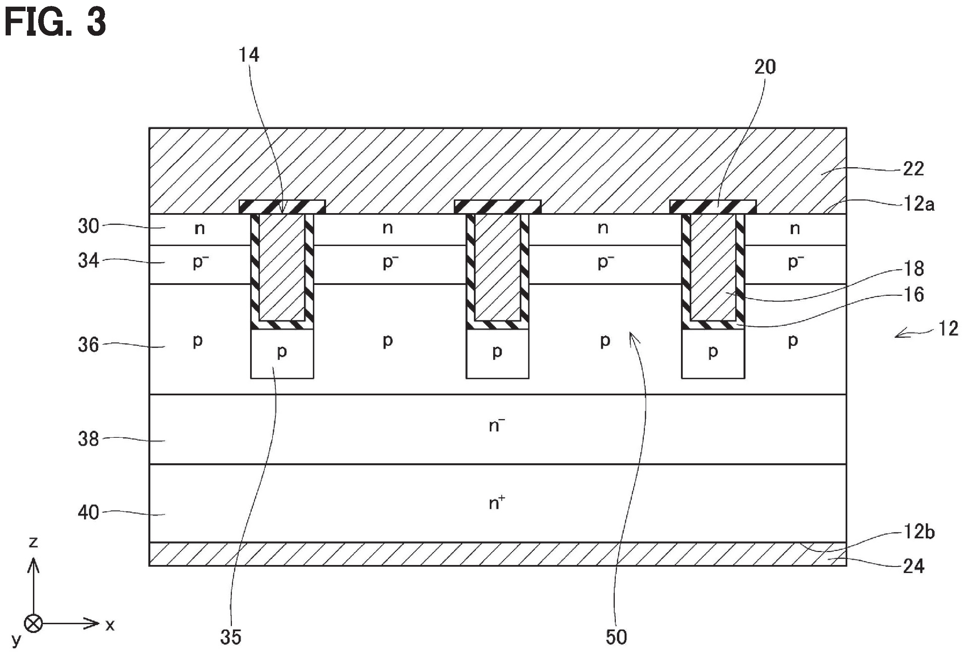

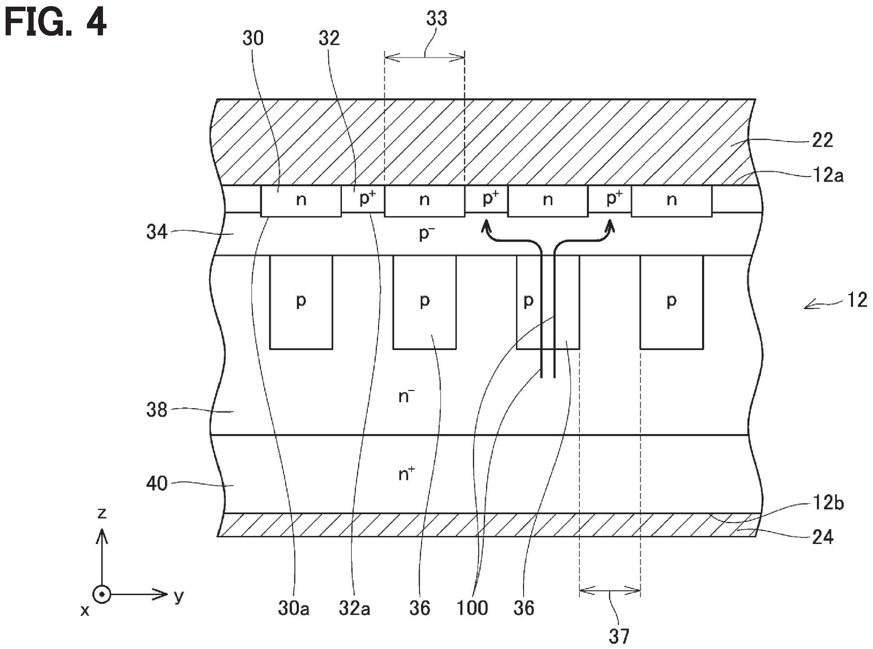

As shown in FIGS. 1 and 4, each of the deep layers 36 is a p-type layer that protrudes downward from the lower surface of the body layer 34. Each of the deep layers 36 extends from the lower surface of the body layer 34 to a position lower than the lower end of each trench 14. When the semiconductor substrate 12 is viewed from above, as shown in FIG. 5, each of the deep layers 36 extends long in the x direction and intersects with the trench 14 at an angle of approximately 90 degrees. That is, each of the deep layers 36 is distributed across the plural inter-trench regions 50. When the semiconductor substrate 12 is viewed from above, the deep layers 36 are arranged at intervals in the y direction. Hereinafter, the region between the deep layers 36 in the y direction is referred to as an interval 37. As shown in FIG. 3, each of the deep layers 36 is in contact with the gate insulating film 16 on the side surface of the trench 14 located below the body layer 34. Each of the deep layers 36 faces the gate electrode 18 via the gate insulating film 16.

As shown in FIGS. 1 to 3, each of the under-trench layers 35 is a p-type layer disposed under the corresponding trench 14. Each of the under-trench layers 35 extends long along the longitudinal direction (i.e., the y direction) of the corresponding trench 14 and intersects with each of the deep layers 36. Each of the under-trench layers 35 is in contact with the gate insulating film 16 at the bottom surface of the corresponding trench 14.

The drift layer 38 is an n-type layer having an n-type impurity concentration lower than that of the source layers 30. The drift layer 38 is distributed across the lower portions of the inter-trench regions 50. The drift layer 38 is in contact with the deep layers 36 and the under-trench layers 35 from below. The drift layer 38 is distributed in each of the intervals 37 between the deep layers 36. The drift layer 38 is in contact with the side surface of the deep layers 36 and the side surface of the under-trench layers 35 in each of the intervals 37. The drift layer 38 extends through each of the intervals 37 into each of the inter-trench regions 50. The drift layer 38 is in contact with the body layer 34 from below in each of the inter-trench regions 50. The drift layer 38 is in contact with the gate insulating film 16 in each of the inter-trench regions 50. That is, the drift layer 38 is in contact with the gate insulating film 16 on the side surface of the trench 14 located below the body layer 34.

The drain layer 40 is an n-type layer having an n-type impurity concentration higher than that of the drift layer 38. The drain layer 40 is in contact with the drift layer 38 from below. The drain layer 40 is arranged in a region including the lower surface 12b of the semiconductor substrate 12. The drain layer 40 is in ohmic contact with the drain electrode 24.

FIG. 5 shows the positional relationship between the contact layer 32 and the deep layer 36 when the semiconductor substrate 12 is viewed from above. In each of the inter-trench regions 50, the interval 33 of the contact layers 32 is located above the corresponding deep layer 36. In each of the inter-trench regions 50, the interval 37 of the deep layers 36 is located below the corresponding contact layer 32. Each of the contact layers 32 is disposed at position that does not overlap with the deep layer 36 when the semiconductor substrate 12 is viewed from above.

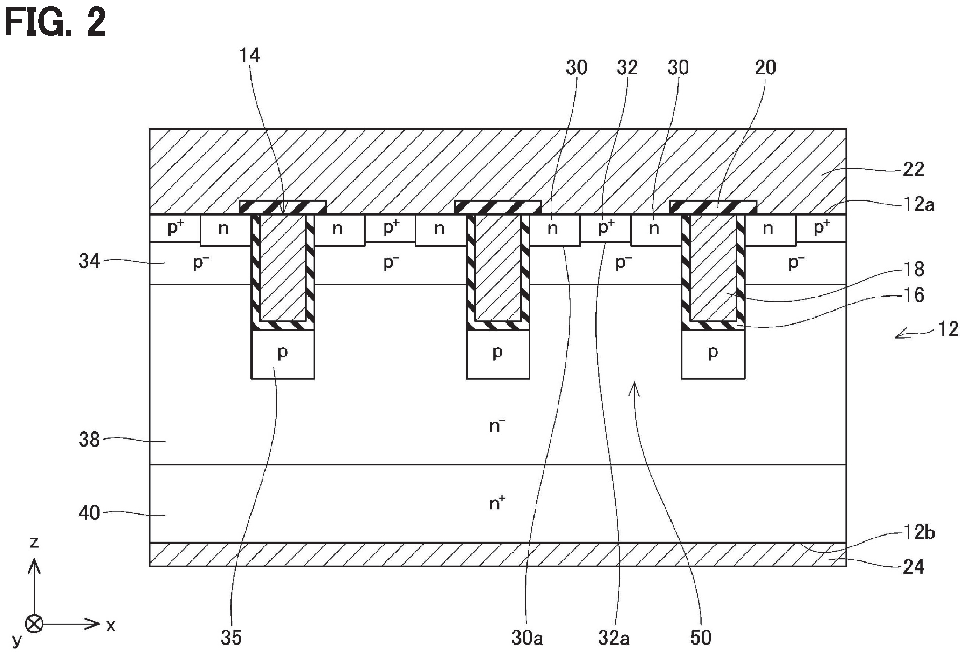

As shown in FIG. 2, the lower end 32a of the contact layer 32 is located above the lower end 30a of the source layer 30. FIG. 6 shows the impurity concentration distribution in the source layer 30, the contact layer 32, and the body layer 34 in the z direction. The lower end 30a of the source layer 30 is defined as a position where the n-type impurity concentration and the p-type impurity concentration are equal to each other. In the body layer 34 (that is, the p-type region below the source layer 30), the p-type impurity concentration is normally distributed with a peak value P1. In this specification, the contact layer 32 is defined as a p-type layer having a p-type impurity concentration higher than the peak value P1. Therefore, the lower end 32a of the contact layer 32 is defined as the position having the same p-type impurity concentration as the peak value P1. As shown in FIG. 6, the lower end 32a of the contact layer 32 is located above the lower end 30a of the source layer 30.

The following describes an operation of the MOSFET 10. When a potential equal to or higher than a gate threshold value is applied to each of the gate electrodes 18, a channel is formed in the body layer 34 in the vicinity of the gate insulating film 16. The source layer 30 and the drift layer 38 are connected by the channel. When the potential of the drain electrode 24 is higher than the potential of the source electrode 22, electrons flow from the source layer 30 through the channel and the drift layer 38 to the drain layer 40. That is, the MOSFET 10 is turned on. When the potential of each gate electrode 18 is reduced to a value below the gate threshold, the channel disappears and the flow of electrons stops. In other words, the MOSFET 10 is turned off. When the MOSFET 10 is turned off, a depletion layer extends from body layer 34 to the drift layer 38. In addition, a depletion layer extends from the deep layer 36 and the under-trench layer 35 into the drift layer 38. The depletion layer extending from the deep layer 36 and the under-trench layer 35 promotes depletion in the semiconductor region around the bottom end of the trench 14. This suppresses the concentration of the electric field on the gate insulating film 16.

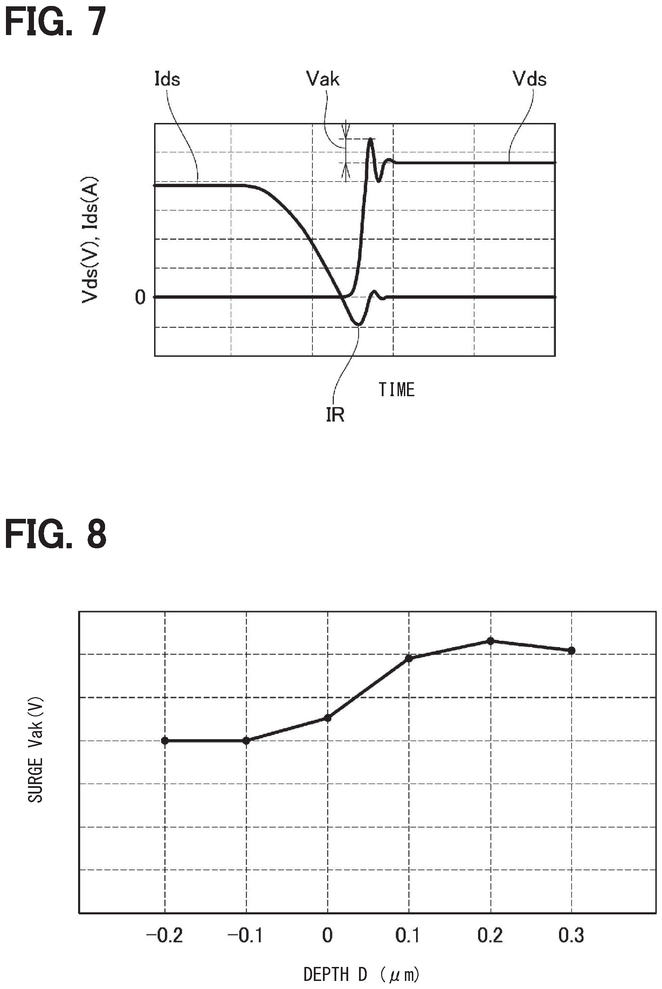

Furthermore, a higher potential than that applied to the drain electrode 24 may be applied to the source electrode 22. When a potential higher than that of the drain electrode 24 is applied to the source electrode 22, a diode formed by a pn junction at the interface between the p-type layer (i.e., the p-type layer formed by the body layer 34, the under-trench layer 35, and the deep layer 36) and the drift layer 38 turns on. That is, holes flow from the p-type layer to the drift layer 38, and electrons flow from the drift layer 38 to the p-type layer. Thereafter, when the voltage applied to the MOSFET 10 is changed so that the potential of the source electrode 22 becomes lower than the potential of the drain electrode 24, a recovery operation occurs in the diode. FIG. 7 shows change in the drain-source voltage Vds and the drain current Ids during the recovery operation. In the recovery operation, a depletion layer develops from the pn junction at the interface between the p-type layer and the drift layer 38 into the drift layer, and holes in the drift layer 38 are discharged to the source electrode 22 via the p-type layer. This causes a recovery current IR to flow, as shown in FIG. 7. As a result, a surge voltage Vak occurs between the source electrode 22 and the drain electrode 24. In this embodiment, since the deep layer 36 protrudes toward the drift layer 38, holes tend to flow from the drift layer 38 into the deep layer 36 during the recovery operation. Therefore, as indicated by arrows 100 in FIG. 4, holes are discharged from the drift layer 38 through the deep layer 36, the body layer 34, and the contact layer 32 to the source electrode 22. In this embodiment, since the contact layer 32 is not located above the deep layer 36, holes that pass through the deep layer 36 move laterally within the body layer 34 and then flow into the contact layer 32. Therefore, the resistance of the path through which the holes flow is high. Thus, the recovery current IR is suppressed, and the surge voltage Vak is suppressed.

In addition, during recovery operation, the depletion layer extends from the pn junction into the p-type layer. Holes discharged from the depleted p-type layer to the source electrode 22 also constitute the recovery current. In the body layer 34, a depletion layer extends upward from the pn junction. When the depletion layer reaches the lower end 30a of the source layer 30, the depletion layer stops extending upward. In this embodiment, since the lower end 32a of the contact layer 32 is located above the lower end 30a of the source layer 30, the extension of the depletion layer into the contact layer 32 is prevented. This prevents the high concentration holes in the contact layer 32 from being discharged to the source electrode 22 as a recovery current. This further suppresses the recovery current and the surge voltage. FIG. 8 shows the relationship between the depth D of the contact layer 32 and the surge voltage Vak. In FIG. 8, the depth D means a relative position of the lower end 32a of the contact layer 32 in the z direction with respect to the lower end 30a of the source layer 30. When the depth D is positive, the lower end 32a of the contact layer 32 is located above the lower end 30a of the source layer 30. As shown in FIG. 8, the greater the depth D (i.e., the higher the lower end 32a of the contact layer 32 is located), the more the surge voltage Vak is suppressed.

As described above, according to the MOSFET 10 of the embodiment, the recovery current can be suppressed.

In the embodiment, the lower end 32a of the contact layer 32 is located above the lower end 30a of the source layer 30. However, in the thickness direction of the semiconductor substrate 12, the lower end 32a of the contact layer 32 may be located at the same position as the lower end 30a of the source layer 30. That is, the depth D may be zero. As shown in FIG. 8, even when the depth D is zero, the surge voltage Vak is suppressed more than when the depth D is negative.

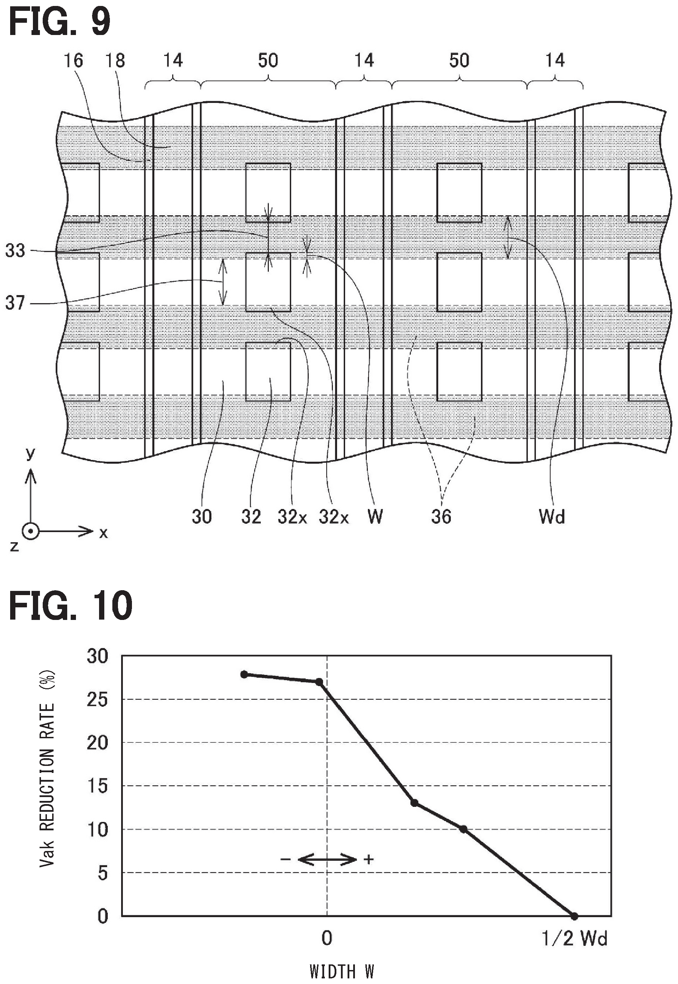

In the embodiment, the contact layer 32 is not located above the deep layer 36. However, as shown in FIG. 9, a portion 32x of the contact layer 32 may be located above the deep layer 36. That is, when the semiconductor substrate 12 is viewed from above, the portion 32x of the contact layer 32 may overlap the deep layer 36. FIG. 10 shows a relationship between a width W (see FIG. 9) of an overlap between the contact layer 32 and the deep layer 36 and a reduction rate of the surge voltage Vak. When the width W is negative, the contact layer 32 and the deep layer 36 do not overlap. In FIG. 10, the width Wd means the width of the deep layer 36 in the y direction (see FIG. 9). When W=1/2Wd, the interval 33 does not exist. As shown in FIG. 10, even when the width W is positive, the surge voltage Vak decreases as the width W decreases from 1/2Wd. In this way, even if the portion 32x of the contact layer 32 overlaps with the deep layer 36, by disposing the interval 33 above the deep layer 36, the resistance of the path of the recovery current can be increased, and the recovery current can be suppressed.

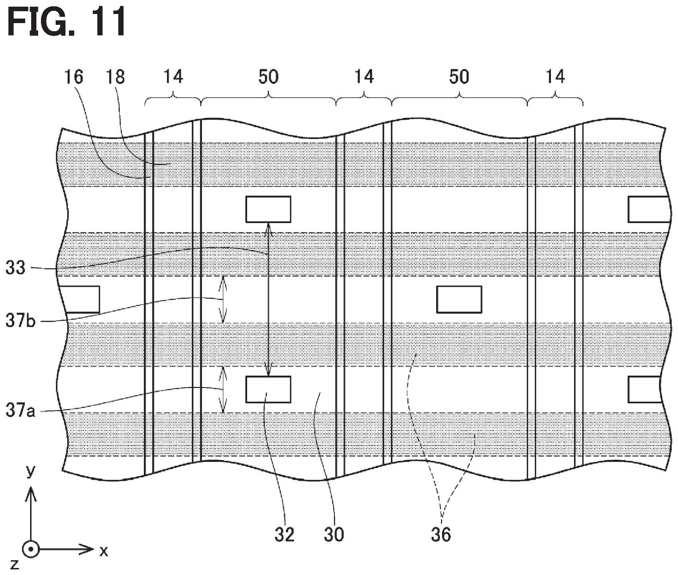

In the embodiment, the contact layer 32 is provided for each of the intervals 37 between the deep layers 36. However, as shown in FIG. 11, in each of the inter-trench regions 50, there may be less contact layer 32 relative to the interval 37. That is, in FIG. 11, the interval 37 has a first part 37a that overlaps with the contact layer 32 when the semiconductor substrate 12 is viewed from above, and a second part 37b that does not overlap with the contact layer 32 when the semiconductor substrate 12 is viewed from above. In this case, the contact layers 32 may be disposed in an evenly distributed manner.

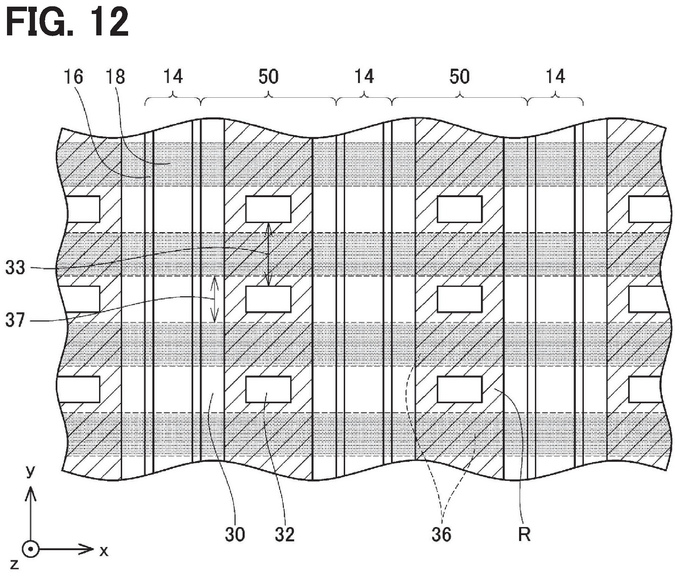

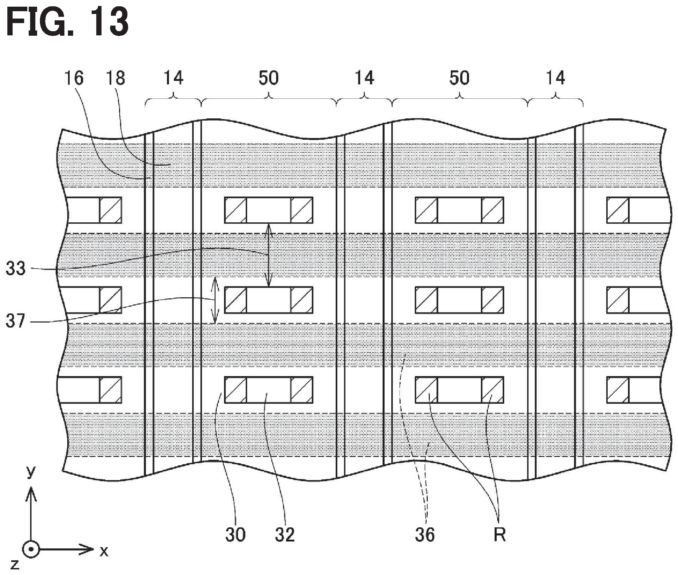

In the embodiment, the source layer 30 is provided over the entire area of the surface layer near the upper surface 12a where the contact layer 32 is not present. However, the distribution range of the source layer 30 may be narrower. FIGS. 12 and 13 show an example in which the distribution range of the source layer 30 is narrower than that in FIG. 5. In FIG. 12 and 13, the hatched region R indicates a region on the upper surface 12a where neither the contact layer 32 nor the source layer 30 is disposed. In the region R, the body layer 34 is in contact with the source electrode 22 on the upper surface 12a. In FIG. 12, the source layer 30 is provided only in the area adjacent to the trench 14. In FIG. 13, the body layer 34 (i.e., the region R) is provided in a range adjacent to the end of the contact layer 32 in the x direction, and the source layer 30 is provided in the other range.

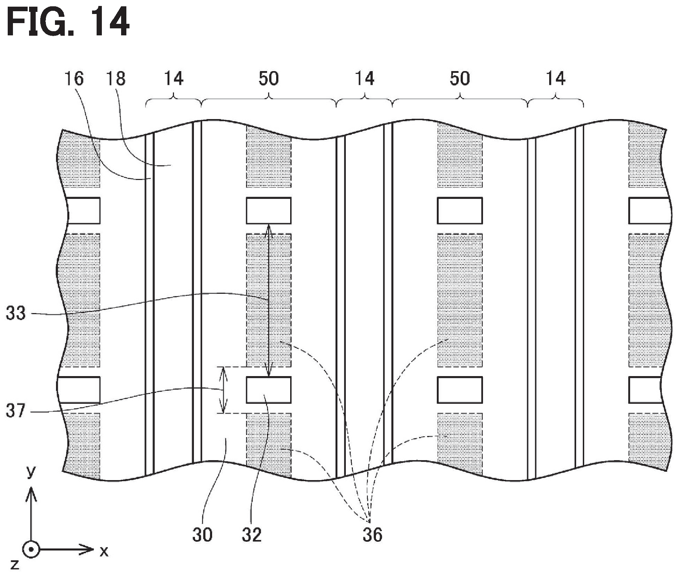

In the embodiment, each of the deep layers 36 extends long in the x direction when the semiconductor substrate 12 is viewed from above. However, as shown in FIG. 14, the deep layer 36 may be provided in a manner distributed in the x direction when the semiconductor substrate 12 is viewed from above. In FIG. 14, the deep layers 36 are distributed in the x direction so that the deep layer 36 is present in each of the inter-trench regions 50. Within each of the inter-trench regions 50, the deep layers 36 are spaced apart in the y direction. The configuration of FIG. 14 also makes it possible to suppress the recovery current.

The configurations of the techniques disclosed in this specification are listed below.

### (Configuration 1)

A field-effect transistor includes:
a semiconductor substrate made of a compound semiconductor and having a plurality of trenches on an upper surface;
a plurality of gate electrodes respectively disposed in the trenches and insulated from the semiconductor substrate by a gate insulating film; and
a source electrode in contact with an upper surface of the semiconductor substrate.

The semiconductor substrate has a plurality of n-type source layers, a plurality of p-type contact layers, a p-type body layer, an n-type drift layer, and a plurality of p-type deep layers.

A semiconductor region located between the plurality of trenches in the semiconductor substrate is an inter-trench region.

The source layers are respectively disposed in the inter-trench regions, in contact with the source electrode, and in contact with a corresponding gate insulating film.

The contact layers are respectively disposed in the inter-trench regions and in contact with the source electrode.

The plurality of contact layers are provided in each of the inter-trench regions.

When the semiconductor substrate is viewed from above, in each of the inter-trench regions, the plurality of contact layers are arranged at intervals in a specific direction parallel to the plurality of trenches.

The body layer has a p-type impurity concentration lower than that of each of the contact layers, and is distributed across the plurality of inter-trench regions to be located below each of the source layers and each of the contact layers, and in contact with the gate insulating film.

The drift layer is distributed across lower regions of the plurality of inter-trench regions, and is in contact with the body layer from below in each of the inter-trench regions, and in contact with the gate insulating film.

Each of the deep layers extends from the body layer to a position lower than a lower end of each of the trenches.

When the semiconductor substrate is viewed from above, the plurality of deep layers are arranged at intervals in the specific direction, in each of the inter-trench regions.

In each of the inter-trench regions, each interval of the contact layers is located above a corresponding one of the deep layers.

In each of the inter-trench regions, each interval of the deep layers is located below a corresponding one of the contact layers.

### (Configuration 2)

In the field-effect transistor of Configuration 1, each of the deep layers intersects each of the trenches when the semiconductor substrate is viewed from above.

### (Configuration 3)

In the field-effect transistor of Configuration 1 or 2, the contact layers and the deep layers do not overlap each other when the semiconductor substrate is viewed from above.

### (Configuration 4)

In the field-effect transistor of any one of Configurations 1 to 3, in each of the inter-trench regions, the interval between the deep layers has a first part that overlaps with the contact layer when the semiconductor substrate is viewed from above, and a second part that does not overlap with the contact layer when the semiconductor substrate is viewed from above.

### (Configuration 5)

In the field-effect transistor of any one of Configurations 1 to 4, in a thickness direction of the semiconductor substrate, the lower end of the contact layer is located at the same position as or higher than the lower end of the source layer.

Although the embodiments have been described in detail above, these are merely examples and do not limit the scope of present disclosure. The techniques described in claims include various modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

## Claims

1. A field-effect transistor comprising:
a semiconductor substrate (12) made of a compound semiconductor and having a plurality of trenches (14) formed on an upper surface of the semiconductor substrate;
a plurality of gate electrodes (18) respectively disposed in the plurality of trenches and insulated from the semiconductor substrate by a gate insulating film; and
a source electrode (22) in contact with the upper surface of the semiconductor substrate, wherein
the semiconductor substrate has a plurality of n-type source layers (30), a plurality of p-type contact layers (32), a p-type body layer (34), an n-type drift layer (38), and a plurality of p-type deep layers (36),
a semiconductor region located between the plurality of the trenches in the semiconductor substrate is an inter-trench region (50),
the source layers are respectively disposed in the inter-trench regions, the source layer being in contact with the source electrode and being in contact with the gate insulating film,
the contact layers are respectively disposed in the inter-trench regions and in contact with the source electrode,
the plurality of contact layers are provided in each of the inter-trench regions,
when the semiconductor substrate is viewed from above, the plurality of contact layers are arranged with an interval (33) in a specific direction parallel to the plurality of trenches in each of the inter-trench regions,
the body layer has a p-type impurity concentration lower than that of each of the contact layers, and is distributed across the plurality of inter-trench regions to be located below each of the source layers and each of the contact layers, and in contact with the gate insulating film,
the drift layer is distributed across lower regions of the plurality of inter-trench regions to be in contact with the body layer from below in each of the inter-trench regions, and in contact with the gate insulating film,
each of the deep layers extends from the body layer to a position lower than a lower end of each of the trenches,
when the semiconductor substrate is viewed from above, the plurality of deep layers are arranged with an interval (37) in the specific direction, in each of the inter-trench regions,
each interval between the contact layers is located above a corresponding one of the deep layers in each of the inter-trench regions, and
each interval between the deep layers is located below a corresponding one of the contact layers in each of the inter-trench regions.

2. The field-effect transistor according to claim 1, wherein each of the deep layers intersects each of the trenches when the semiconductor substrate is viewed from above.

3. The field-effect transistor according to claim 1 or 2, wherein each of the contact layers and each of the deep layers do not overlap each other when the semiconductor substrate is viewed from above.

4. The field-effect transistor according to claim 1 or 2, wherein in each of the inter-trench regions, the interval between the deep layer has a first part (37a) that overlaps with the contact layer when the semiconductor substrate is viewed from above, and a second part (37b) that does not overlap with the contact layer when the semiconductor substrate is viewed from above.

5. The field-effect transistor according to claim 1 or 2, wherein a lower end (32a) of each of the contact layers is located at the same position as or above a lower end (30a) of each of the source layers in a thickness direction of the semiconductor substrate.
